(19) Europäisches Patentamt / European Patent Office / Office européen des brevets

(11) **EP 3 387 666 B1**

(12) **FASCICULE DE BREVET EUROPEEN**

(45) Date de publication et mention
de la délivrance du brevet:
**02.09.2020 Bulletin 2020/36**

(51) Int Cl.:
***H01J 37/32*** *(2006.01)*          ***C23C 14/48*** *(2006.01)*
***H01L 21/223*** *(2006.01)*

(21) Numéro de dépôt: **16825798.8**

(22) Date de dépôt: **05.12.2016**

(86) Numéro de dépôt international:
**PCT/FR2016/000198**

(87) Numéro de publication internationale:
**WO 2017/098092 (15.06.2017 Gazette 2017/24)**

(54) **PROCÉDÉ DE COMMANDE ET ALIMENTATION DE POLARISATION POUR UN IMPLANTEUR IONIQUE FONCTIONNANT EN IMMERSION PLASMA**

STEUERUNGSVERFAHREN UND VORSPANNUNGSVERSORGUNG FÜR EIN PLASMAIMMERSIONS-IONENIMPLANTER

CONTROL METHOD AND BIAS SUPPLY FOR A PLASMA IMMERSION ION IMPLANTER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.12.2015 FR 1502569**

(43) Date de publication de la demande:
**17.10.2018 Bulletin 2018/42**

(73) Titulaire: **Ion Beam Services**
**13790 Peynier (FR)**

(72) Inventeurs:
• **TORREGROSA, Frank**
**13109 Simiane (FR)**

• **ROUX, Laurent**
**13013 Marseille (FR)**

(74) Mandataire: **Cabinet Prugneau-Schaub**
**Europole - Le Grenat**
**3, avenue Doyen Louis Weil**
**38000 Grenoble (FR)**

(56) Documents cités:
| | |
|---|---|
| **WO-A1-01/15200** | **WO-A2-02/25694** |
| **WO-A2-2012/168575** | **FR-A1- 2 998 707** |
| **JP-A- H10 142 400** | **US-B1- 8 461 554** |

**Description**

La présente invention concerne un procédé de commande et une alimentation de polarisation pour un implanteur ionique fonctionnant en immersion plasma.

Le domaine de l'invention est celui des implanteurs ioniques opérant en mode immersion plasma. Ainsi, l'implantation ionique d'un substrat consiste à l'immerger dans un plasma et à le polariser en tension négative, de quelques dizaines de Volts à quelques dizaines de kilovolts (généralement moins de 100 kV), ceci de façon à créer un champ électrique capable d'accélérer les ions du plasma vers le substrat de sorte qu'ils s'y implantent. Les atomes ainsi implantés sont dénommés dopants.

La profondeur de pénétration des ions est déterminée par leur énergie d'accélération. Elle dépend d'une part de la tension appliquée au substrat et d'autre part de la nature respective des ions et du substrat. La concentration d'atomes implantés dépend de la dose qui s'exprime en nombre d'ions par $cm^2$ et de la profondeur d'implantation.

Pour des raisons liées à la physique des plasmas, il se crée, en quelques nanosecondes après l'application de la tension, une gaine ionique autour du substrat. La différence de potentiel responsable de l'accélération des ions vers le substrat se retrouve aux bornes de cette gaine.

La croissance de cette gaine en fonction du temps suit l'équation de Child-Langmuir :

$$j_c = \frac{4}{9} \varepsilon_0 \left( \frac{2e}{M} \right)^{1/2} \frac{V_0^{3/2}}{s^2}$$

où :

$j_c$ : densité de courant,
$\varepsilon_0$ : permitivité du vide,
e : charge de l'ion,
M : masse de l'ion,
$V_0$ : différence de potentiel au travers de la gaine, et
s : épaisseur de la gaine.

En stipulant que la densité de courant est égale à la charge traversant la limite de la gaine par unité de temps, ds/dt représente la vitesse de déplacement de cette limite :

$$\frac{ds}{dt} = \frac{2}{9} \frac{s_0^2 \cdot u_0}{s^2}$$

Expression dans laquelle $s_0$ vaut :

$$s_0 = \left( \frac{2\varepsilon_0 V_0}{e.n_0} \right)^{1/2}$$

étant entendu que $u_0 = (2eV_0 / M)$ est la vitesse caractéristique de l'ion et que $n_0$ est la densité du plasma.

L'épaisseur de la gaine est liée principalement à la tension appliquée, à la densité du plasma et à la masse des ions.

L'impédance équivalente du plasma qui conditionne le courant d'implantation est directement proportionnelle au carré de l'épaisseur de gaine. Le courant d'implantation décroît donc très rapidement lorsque la gaine augmente.

Au bout d'un certain laps de temps, il est nécessaire de procéder à une réinitialisation. Ceci s'avère pratiquement indispensable lorsque la gaine atteint les parois de l'enceinte stoppant ainsi le mécanisme d'implantation.

Afin de réinitialiser le système, il est donc courant d'arrêter la haute tension sur le substrat tout en maintenant le plasma allumé. Il faut donc disposer d'un générateur puisé qui produit des impulsions de haute tension.

Ainsi, en référence à la figure 1, le document WO 01 / 15200 propose de polariser le substrat au moyen d'une alimentation qui comporte :

- un générateur GEN dont le pôle positif est raccordé à la masse,
- un condensateur Ct en parallèle sur le générateur GEN,
- un premier interrupteur IT1 dont le premier pôle est raccordé au pôle négatif du générateur GEN et dont le second pôle est raccordé à la borne de sortie O de cette alimentation, et
- un deuxième interrupteur IT2 dont le premier pôle est raccordé à la borne de sortie O et dont le second pôle est raccordé à la masse.

Le procédé comporte les phases suivantes :

- phase d'implantation durant laquelle :

  ◦ l'alimentation plasma est activée,
  ◦ le premier interrupteur IT1 est fermé,
  ◦ le deuxième interrupteur IT2 est ouvert ;

- phase de neutralisation durant laquelle :

  ◦ le premier interrupteur IT1 est ouvert,
  ◦ le deuxième interrupteur IT2 est fermé.

La présence continue du plasma dans l'enceinte donne lieu à des effets secondaires indésirables :

- génération de particules ou poussières,

- apport thermique au substrat,
- agression de l'enceinte en générant des risques de contamination métallique des pièces traitées,
- création d'effets de charge, particulièrement gênants dans le cas des applications microélectroniques, et
- implantation à tension d'accélération non stabilisée pendant les phases de montée et de descente de la tension appliquée au substrat.

Par ailleurs, le document US 2007/069157 prévoit la succession des opérations suivantes :

- activation de l'alimentation du substrat,
- après un certain délai, activation de l'alimentation du plasma pour la durée d'une impulsion,
- désactivation de l'alimentation du plasma,
- après une certaine période, désactivation de l'alimentation du substrat.

Il s'ensuit que durant ladite période, l'alimentation du substrat est activée et l'alimentation du plasma est désactivée, ce qui correspond à une phase de relaxation.

Durant la phase d'implantation, les zones du substrat qui sont électriquement isolantes se chargent positivement et ceci de manière cumulative. Il va sans dire que cette situation n'est pas souhaitable ne serait ce qu'en raison des perturbations apportées au processus d'implantation. Il est donc souhaitable de neutraliser ces charges positives en apportant des électrons.

On peut ainsi prévoir un filament, mais celui-ci tend à se vaporiser. On peut également prévoir un canon à électrons, mais il s'agit là d'un équipement additionnel relativement lourd.

Il convient donc de faciliter la neutralisation des charges positives.

Ainsi, le document WO2013/057390 vise un procédé de commande d'un implanteur ionique comportant une alimentation plasma et une alimentation substrat, cette alimentation substrat comprenant :

- un générateur électrique dont le pôle positif est raccordé à la masse,
- un premier interrupteur dont le premier pôle est raccordé au pôle négatif du générateur et dont le second pôle est raccordé à la borne de sortie de cette alimentation substrat,
- un deuxième interrupteur dont le premier pôle est raccordé à cette borne de sortie et dont le second pôle est relié à une borne de neutralisation,

procédé comportant une phase d'implantation durant laquelle :

- l'alimentation plasma est activée,
- le premier interrupteur est fermé,
- le deuxième interrupteur est ouvert,

procédé comportant aussi une phase de neutralisation durant laquelle :

- le premier interrupteur est ouvert,
- le deuxième interrupteur est fermé,
procédé comportant encore une phase de relaxation durant laquelle :
l'alimentation plasma est inactivée.

La phase de neutralisation comprend une étape préliminaire pour fermer le deuxième interrupteur, cette étape préliminaire étant suivie par une étape d'annulation pour activer l'alimentation plasma.

Ainsi, lors de l'étape d'annulation, les charges positives du substrat sont neutralisées par les électrons du plasma.

La plupart des effets secondaires indésirables mentionnés plus haut sont maintenant réduits de manière significative si ce n'est annulés.

Toutefois, lors des procédés plasma, notamment pour des plasmas d'espèces électronégatives (plasmas fluorés par exemple), des poussières sont générées par un mécanisme d'agglomération. Suivant ce mécanisme, un atome neutre de nature électronégative (atome de fluor par exemple) vient capturer un électron du plasma pour former un ion négatif ($F^-$ dans le cas présent). Cet ion négatif va ensuite s'agglomérer avec un ion positif pour former un complexe (complexe fluoré dans notre exemple) qui va à son tour capturer des électrons du plasma, se charger négativement, attirer d'autres ions positifs et croître ainsi cumulativement dans le plasma pour former une poussière. Cette croissance prend fin lorsque la masse de la poussière devient conséquente ou bien lorsque le champ électromagnétique générant le plasma cesse. La poussière tombe alors sur le substrat en cours de traitement du fait de la gravité.

Ce mécanisme d'agglomération est bien connu et l'on a donc recours à une stratégie d'utilisation de plasmas pulsés associés à des flux de gaz optimisés, notamment lors de l'extinction du plasma. Cela permet de réduire la taille des particules et de les évacuer dans la ligne de pompage avant qu'elles ne tombent sur le substrat.

Cependant, cette stratégie s'avère insuffisante avec la miniaturisation de plus en plus poussée des composants électroniques. Dans le cas de l'implantation par immersion plasma, lors des impulsions de tension négative, les ions positifs du plasma sont accélérés vers le substrat pour y être implantés. Pendant ces impulsions, le substrat voit un flux important de charges positives et sa surface est susceptible de se charger positivement, notamment si elle comporte des matériaux non conducteurs tels que des oxydes, des nitrures ou de la résine photolithographique. Pour éviter une accumulation excessive de charges positives pouvant conduire à des phénomènes d'arcage, le plasma doit être maintenu allumé un certain temps (quelques dizaines de $\mu$s) après l'arrêt de l'impulsion négative. Les charges positives de surface sont alors neutralisées par les électrons provenant du plasma. On peut même améliorer cette neutralisation en appliquant un potentiel positif au substrat entre les impulsions négatives

Il apparaît pourtant que si les électrons sont attirés par le substrat, il en va de même pour les particules chargées négativement qui s'accumulent sur sa surface.

Incidemment, le document FR 2 998 707 divulgue lui-aussi les caractéristiques d'un procédé de commande pour implantation en immersion plasma. De plus, ce document prévoit une phase d'initialisation durant laquelle le substrat est polarisé négativement et l'alimentation plasma est éteinte. Toutefois, la phase d'initialisation a une durée inférieure à 5μs.

Cette durée est largement insuffisante pour éliminer les particules chargées négativement.

La présente invention a ainsi pour objet d'éviter que de telles particules ne viennent polluer le substrat.

Selon l'invention, un procédé de commande pour un implanteur ionique fonctionnant en immersion plasma, tel que défini par la revendication 1, comporte :

- une phase d'implantation durant laquelle le plasma est allumé et le substrat est polarisé négativement,
- une phase de neutralisation durant laquelle le plasma est allumé et le substrat se voit appliquer une polarisation positive ou nulle,
- une phase de suppression durant laquelle le plasma est éteint,
- une phase d'expulsion de particules chargées négativement au niveau du substrat durant laquelle le plasma est éteint, procédé dans lequel la durée de cette phase d'expulsion est supérieure à 5 μs, procédé remarquable en ce qu'il comporte, suite à la phase d'expulsion, une phase de préparation durant laquelle le plasma est éteint et le substrat se voit appliquer une polarisation positive ou nulle.

De préférence, durant la phase d'expulsion le substrat est polarisé négativement.

Eventuellement, l'implanteur comprenant une électrode de récupération agencée à la périphérie du substrat, durant la phase d'expulsion cette électrode est polarisée positivement.

Suivant un mode de réalisation privilégié, durant la phase de suppression le substrat se voit appliquer une polarisation positive ou nulle.

L'invention vise également une alimentation de polarisation d'un implanteur ionique, tel que défini par la revendication 5, qui comprend :

- un premier générateur électrique dont le pôle positif est raccordé à la masse,
- un premier interrupteur dont le premier pôle est raccordé au pôle négatif du premier générateur et dont le second pôle est raccordé à la borne de sortie de cette alimentation,
- un deuxième interrupteur dont le premier pôle est raccordé à une borne de compensation et le second pôle est raccordé à cette borne de sortie,

alimentation remarquable en ce qu'elle comprend un générateur auxiliaire dont le pôle positif est raccordé à une borne de liaison, et un troisième interrupteur dont le premier pôle est raccordé au pôle négatif du générateur auxiliaire et le second pôle est raccordé à la borne de sortie.

Eventuellement, cette borne de liaison est raccordée à la masse.

Alternativement, cet implanteur comportant une électrode de récupération, la borne de liaison est raccordée à cette électrode de récupération.

Suivant une première option, la borne de compensation est raccordée à la masse.

Suivant une seconde option, la borne de compensation est reliée au pôle positif d'un deuxième générateur, le pôle négatif de ce deuxième générateur étant relié à la masse.

La présente invention apparaîtra maintenant avec plus de détails dans le cadre de la description qui suit d'exemples de réalisation donnés à titre illustratif en se référant aux figures jointes parmi lesquelles :

- la figure 1 représente une alimentation haute tension selon l'état de l'art,
- la figure 2 représente un implanteur ionique pourvu d'un module de commande,
- la figure 3 représente un premier mode de réalisation d'une alimentation électrique haute tension selon l'invention,
- la figure 4 représente un diagramme temporel schématisant le procédé de l'invention selon ce premier mode de réalisation,
- la figure 5 représente un deuxième mode de réalisation d'une alimentation électrique haute tension selon l'invention, et
- la figure 6 représente un diagramme temporel schématisant le procédé de l'invention selon ce deuxième mode de réalisation.

Les éléments présents sur plusieurs figures sont affectés d'une seule et même référence.

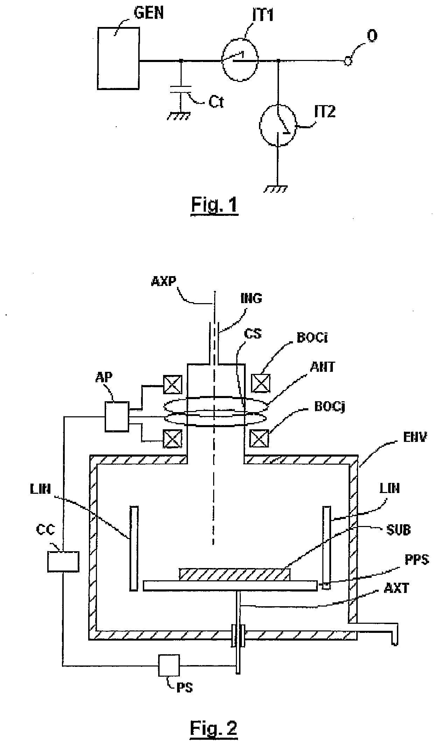

En référence à la figure 2, un implanteur ionique comporte plusieurs éléments agencés à l'intérieur et à l'extérieur d'une enceinte à vide ENV. Pour les applications microélectroniques, il est préconisé d'utiliser une enceinte en alliage d'aluminium si l'on souhaite limiter la contamination en éléments métalliques tels que Fer, Chrome, Nickel ou Cobalt. Un revêtement en silicium ou en carbure de Silicium peut aussi être utilisé.

Un plateau porte substrat PPS, se présentant sous la forme d'un disque à plan horizontal, mobile autour de son axe vertical AXT, reçoit le substrat SUB devant subir l'implantation ionique.

A proximité du substrat SUB, figure une électrode de récupération telle qu'un anneau concentrique à ce substrat SUB. Cette électrode peut aussi prendre la forme de plaques de protection LIN (« liner » en anglais) disposées verticalement à la périphérie du substrat SUB pour protéger l'enceinte ENV.

La partie supérieure de l'enceinte ENV reçoit le corps de source plasma CS, cylindrique, d'axe vertical AXP. Ce corps est en quartz. Il est extérieurement entouré, d'une part par des bobines de confinement BOCi, BOCj, et d'autre part par une antenne radiofréquence ANT extérieure. L'entrée de gaz plasmagène ING est coaxiale à l'axe vertical AXP du corps de source CS. Cet axe vertical AXP rencontre la surface du plateau porte substrat PPS sur lequel est disposé le substrat à implanter SUB.

Il est possible d'utiliser tout type de source plasma pulsée : décharge, ICP (pour « Inductively Coupled Plasma » en anglais), Helicon, micro-ondes, arc. Ces sources doivent travailler à des niveaux de pression suffisamment faibles pour que le champ électrique créé entre le plateau PPS à haute tension et l'enceinte ENV à la masse n'allume pas un plasma de décharge qui vienne perturber le fonctionnement pulsé de la source.

Le module de commande de l'implanteur ionique comporte essentiellement trois éléments :

- une alimentation substrat PS pour fournir la haute tension au substrat SUB,
- une alimentation plasma AP pour alimenter l'antenne radiofréquence ANT et les bobines de confinement BOCi, BOCj (on entend ici alimentation au sens large car il y a naturellement une source pour l'antenne et au moins une source distincte pour les bobines),
- un circuit de contrôle CC pour piloter ces deux alimentations.

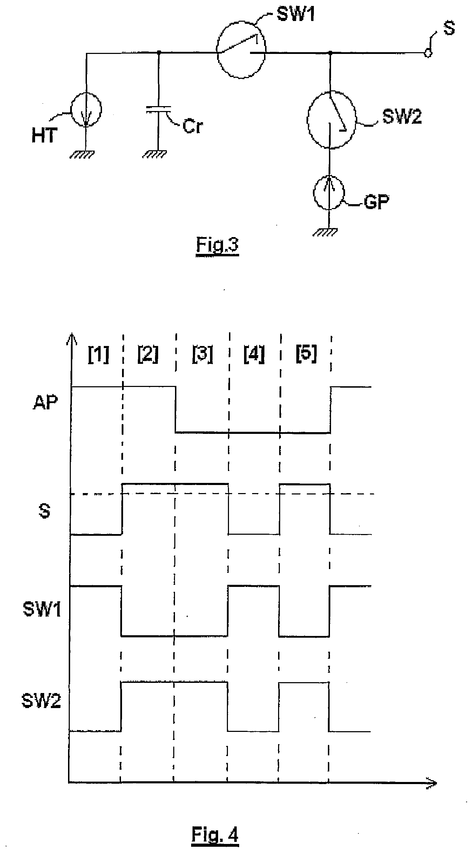

En référence à la figure 3, l'alimentation substrat PS comporte :

- un premier générateur haute tension HT dont le pôle positif est raccordé à la masse,
- un premier interrupteur SW1 dont le premier pôle est raccordé au pôle négatif du premier générateur HT et dont le second pôle est raccordé à la borne de sortie S de cette alimentation,
- un deuxième interrupteur SW2 dont le premier pôle est raccordé à la borne de sortie S et dont le second pôle est relié au pôle positif d'un second générateur GP,
- le second générateur GP ayant son pôle négatif raccordé à la masse,
- de préférence, un condensateur de régulation Cr connecté en parallèle sur le premier générateur HT.

La borne de sortie S est raccordée au plateau porte-substrat PPS de l'implanteur.

La tension positive du second générateur GP, généralement comprise entre 0 et 100 Volts, est avantageusement choisie sensiblement égale au potentiel plasma qui est souvent compris entre + 10 et + 20 Volts.

En référence à la figure 4, le circuit de contrôle CC pilote l'alimentation plasma AP et les deux interrupteurs SW1, SW2 de l'alimentation substrat PS comme suit.

Au début d'un cycle, prend place la phase d'implantation [1] :

- l'alimentation plasma AP est allumée,
- le premier interrupteur SW1 est fermé,
- le second interrupteur SW2 est ouvert.

Cette phase d'implantation a une durée typique de 5 μs à 100 μs.

A la suite de cette phase d'implantation, vient une phase de neutralisation [2] :

- l'alimentation plasma AP est toujours allumée,
- le premier interrupteur SW1 est ouvert,
- le second interrupteur SW2 est fermé.

Les électrons du plasma sont attirés par le potentiel positif de surface, il y a neutralisation. On remarquera ici qu'il est possible de supprimer le second générateur GP, auquel cas le second interrupteur SW2 est raccordé à la masse. Cette phase de neutralisation a une durée typique de 50 μs à 200 μs.

Vient ensuite une phase de suppression [3] :

- l'alimentation plasma AP est maintenant inhibée,
- le premier interrupteur SW1 reste ouvert,
- le second interrupteur SW2 reste fermé.

Cette phase de suppression a une durée typique de 50 μ$ à 200 μs.

A la suite de cette phase de suppression, il survient une phase d'expulsion [4] :

- l'alimentation plasma AP est toujours inhibée,
- le second interrupteur SW2 s'ouvre,
- l'expulsion des particules chargées négativement est réalisée au moyen de l'une, de l'autre ou des deux opérations suivantes :

    ○ le premier interrupteur SW1 se ferme,
    ○ l'électrode de récupération LIN est connectée à une tension positive (connexion non représentée sur la figure).

Les particules négatives accumulées sur la surface du substrat SUB sont chassées par effet électrostatique. Cette phase d'expulsion a une durée typique de 5 μs à 100 μs.

Si l'électrode de récupération LIN est polarisée positivement, elle va accumuler ces particules et elle peut les larguer lorsqu'elle n'est plus polarisée au risque de contaminer à nouveau le substrat. Il est donc prudent de prévoir une période de nettoyage de cette électrode. A titre d'exemple, on arrête la polarisation positive ou même on applique une polarisation négative en présence d'un fort flux de gaz de sorte que les particules soient évacuées par la chaîne de pompage. Cette opération de nettoyage doit bien sûr se dérouler en dehors de tout traitement d'implantation, par exemple entre le traitement de deux substrats ou de deux lots ou bien encore lors d'une maintenance de l'implanteur.

Vient ensuite, de manière optionnelle, une cinquième phase dite phase de préparation [5] :

-    l'alimentation plasma AP est toujours inhibée,
-    le premier interrupteur SW1 est ouvert,
-    le second interrupteur SW2 se ferme.

Cette phase de préparation a une durée typique de 50 μs à 200 μs.

A titre d'exemple, le procédé ci-dessus est employé pour implanter du bore au moyen d'un plasma $BF_3$ sur un subtrat silicium de 300 mm de diamètre. La tension de polarisation négative HT est égale à 2 kV. La dose implantée vaut $10^{16}/cm^2$.

Dans ces conditions, le nombre de particules de diamètres supérieurs à 65 nm sur le substrat est compris entre 1 et 8. Sans l'utilisation de ce procédé, le nombre de particules de diamètres supérieurs à 65 nm sur le substrat est compris entre 30 et 1 000.

Il est toutefois possible que survienne un allumage par décharge du plasma durant la phase d'expulsion [4]. On peut améliorer cette situation en modifiant quelque peu l'alimentation PS du substrat.

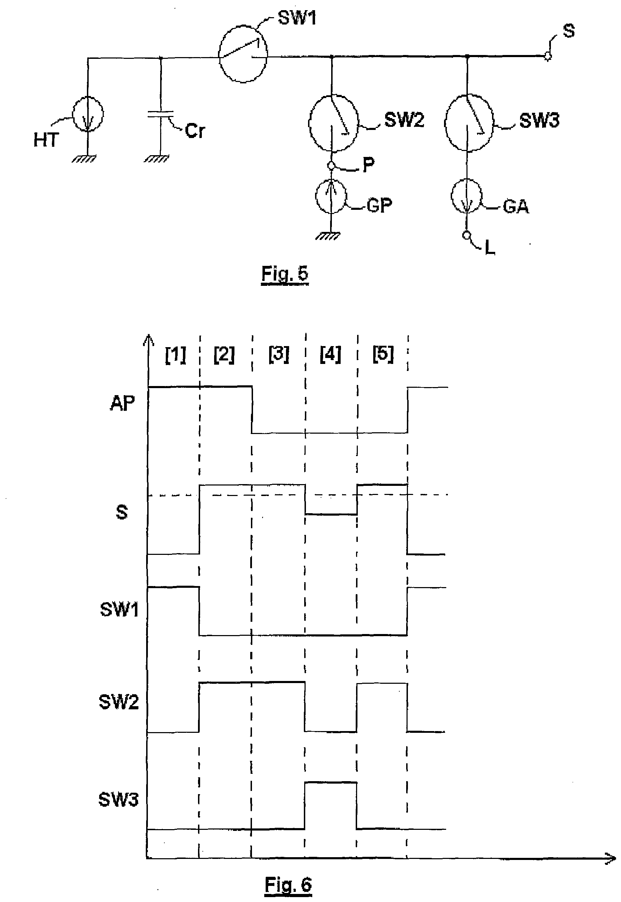

En référence à la figure 5, l'alimentation substrat PS comporte :

-    un premier générateur haute tension HT dont le pôle positif est raccordé à la masse,
-    un premier interrupteur SW1 dont le premier pôle est raccordé au pôle négatif du premier générateur HT et dont le second pôle est raccordé à la borne de sortie S de cette alimentation,
-    un deuxième interrupteur SW2 dont le premier pôle est raccordé à la borne de sortie S et dont le second pôle est relié à une borne de compensation P,
-    cette borne de compensation P est raccordée :

     ◦ soit à la masse (cas non représenté sur la figure),
     ◦ soit au pôle positif d'un deuxième générateur GP (cas représenté sur la figure),

-    le second générateur GP ayant son pôle négatif raccordé à la masse,
-    un troisième interrupteur SW3 dont le premier pôle est raccordé à la borne de sortie S et dont le second pôle est relié au pôle négatif d'un générateur auxiliaire GA,
-    le générateur auxiliaire GA ayant son pôle positif raccordé à une borne de liaison L qui est connectée à la masse ou, éventuellement, à l'électrode de récupération LIN,
-    de préférence, un condensateur de régulation Cr connecté en parallèle sur le premier générateur HT.

La borne de sortie S est raccordée au plateau porte-substrat PPS de l'implanteur.

La tension du générateur auxiliaire GA est inférieure à celle du premier générateur HT de sorte que l'on évite un amorçage dans l'enceinte.

En référence à la figure 6, le procédé est alors modifié comme suit. Au début d'un cycle, prend place la phase d'implantation [1] :

-    l'alimentation plasma AP est allumée,
-    le premier interrupteur SW1 est fermé,
-    le second interrupteur SW2 est ouvert,
-    le troisième interrupteur SW3 est ouvert.

Cette phase d'implantation a une durée typique de 5 μs à 100 μs.

A la suite de cette phase d'implantation, vient une phase de neutralisation [2] :

-    l'alimentation plasma AP est toujours allumée,
-    le premier interrupteur SW1 est ouvert,
-    le second interrupteur SW2 est fermé,
-    le troisième interrupteur SW3 est ouvert.

Cette phase de neutralisation a une durée typique de 50 μs à 200 μs. Vient ensuite une phase de suppression [3] :

-    l'alimentation plasma AP est maintenant inhibée,
-    le premier interrupteur SW1 reste ouvert,
-    le second interrupteur SW2 reste fermé,
-    le troisième interrupteur SW3 reste ouvert.

Cette phase de suppression a une durée typique de 50 μs à 200 μs.

A la suite de cette phase de suppression, il survient une phase d'expulsion [4] :

-    l'alimentation plasma AP est toujours inhibée,
-    le premier interrupteur SW1 reste ouvert,
-    le second interrupteur SW2 s'ouvre,
-    le troisième interrupteur SW3 se ferme et, éventuellement, l'électrode de récupération LIN est connectée à une tension positive (connexion non représentée sur la figure), par exemple au pôle positif du générateur auxiliaire GA.

Le substrat est à nouveau polarisé négativement mais sans plasma. Cette phase d'expulsion a une durée typique de 5 μs à 100 μs.

Vient ensuite, de manière obligatoire, une cinquième phase dite phase de préparation [5] :

- l'alimentation plasma AP est toujours inhibée,
- le premier interrupteur SW1 reste ouvert,
- le second interrupteur SW2 se ferme,
- le troisième interrupteur SW3 s'ouvre.

Cette phase de préparation a une durée typique de 50 µs à 200 µs.

Les exemples de réalisation de l'invention présentés ci-dessus ont été choisis eu égard à leurs caractères concrets. Il ne serait cependant pas possible de répertorier de manière exhaustive tous les modes de réalisation que recouvre cette invention. En particulier, toute étape ou tout moyen décrit peut être remplacé par une étape ou un moyen équivalent sans sortir du cadre de la présente invention. L'invention est définie par les revendications.

## Revendications

1. Procédé de commande pour un implanteur ionique fonctionnant en immersion plasma d'un substrat, comportant :

   - une phase d'implantation ([1]) durant laquelle le plasma (AP) est allumé et le substrat (SUB) est polarisé négativement (S),
   - une phase de neutralisation ([2]) durant laquelle le plasma (AP) est allumé et le substrat (SUB) se voit appliquer une polarisation positive ou nulle (S),
   - une phase de suppression ([3]) durant laquelle le plasma (AP) est éteint,
   - une phase d'expulsion ([4]) de particules chargées négativement au niveau du substrat (SUB) durant laquelle le plasma (AP) est éteint,

   dans lequel la durée de ladite phase d'expulsion est supérieure à 5 µs, et **caractérisé en ce qu'**il comporte, suite à ladite phase d'expulsion ([4]), une phase de préparation ([5]) durant laquelle le plasma (AP) est éteint et le substrat (SUB) se voit appliquer une polarisation positive ou nulle (S).

2. Procédé selon la revendication 1 **caractérisé en ce que**, durant ladite phase d'expulsion ([4]) le substrat (SUB) est polarisé négativement (S).

3. Procédé selon l'une quelconque des revendications 1 à 2 **caractérisé en ce que**, ledit implanteur ionique comprenant une électrode de récupération (LIN) à la périphérie du substrat (SUB), durant ladite phase d'expulsion ([4]) ladite électrode est polarisée positivement.

4. Procédé selon l'une quelconque des revendications précédentes, **caractérisé en ce que** durant ladite phase de suppression ([3]) le substrat (SUB) se voit appliquer une polarisation positive ou nulle (S).

5. Alimentation de polarisation d'un implanteur ionique comprenant :

   - un premier générateur électrique (HT) dont le pôle positif est raccordé à la masse,
   - un premier interrupteur (SW1) dont le premier pôle est raccordé au pôle négatif dudit premier générateur (HT) et dont le second pôle est raccordé à la borne de sortie (S) de cette alimentation (PS),
   - un deuxième interrupteur (SW2) dont le premier pôle est raccordé à une borne de compensation (P) et le second pôle est raccordé à ladite borne de sortie (S),

   **caractérisé en ce qu'**il comprend un générateur auxiliaire (GA) dont le pôle positif est raccordé à une borne de liaison (L), et un troisième interrupteur (SW3) dont le premier pôle est raccordé au pôle négatif du générateur auxiliaire (GA) et le second pôle est raccordé à ladite borne de sortie (S).

6. Alimentation selon la revendication 5, **caractérisée en ce que** ladite borne de liaison (L) est raccordée à la masse.

7. Alimentation selon la revendication 5 **caractérisée en ce que**, cet implanteur ionique comportant une électrode de récupération (LIN), ladite borne de liaison (L) est raccordée à cette électrode de récupération.

8. Alimentation selon l'une quelconque des revendications 5 à 7, **caractérisée en ce que** ladite borne de compensation (P) est raccordée à la masse.

9. Alimentation selon l'une quelconque des revendications 5 à 7, **caractérisée en ce que** ladite borne de compensation (P) est reliée au pôle positif d'un deuxième générateur (GP), le pôle négatif de ce deuxième générateur (GP) étant relié à la masse.

## Patentansprüche

1. Steuerungsverfahren für einen mit Plasmaimmersion eines Substrats arbeitenden Ionenimplanter, umfassend:

   - eine Implantationsphase ([1]), während der das Plasma (AP) gezündet ist und das Substrat (SUB) negativ polarisiert ist (S),
   - eine Neutralisationsphase ([2]), während der das Plasma (AP) gezündet ist und an das Substrat (SUB) eine positive oder keine Polarisation angelegt ist (S),
- eine Suppressionsphase ([3]), während der das Plasma (AP) erloschen ist,
- eine Phase des Ausstoßens ([4]) von negativ geladenen Partikeln auf Ebene des Substrats (SUB), während der das Plasma (AP) erloschen ist,

wobei die Dauer dieser Ausstoßphase größer als 5 $\mu$s ist, und
**dadurch gekennzeichnet, dass** es nach der Ausstoßphase ([4]) eine Vorbehandlungsphase ([5]) umfasst, während der das Plasma (AP) erloschen ist und an das Substrat (SUB) eine positive oder keine Polarisation angelegt ist (S).

2. Verfahren nach Anspruch 1, **dadurch gekennzeichnet, dass** das Substrat (SUB) während der Ausstoßphase ([4]) negativ polarisiert ist (S).

3. Verfahren nach einem der Ansprüche 1 bis 2, **dadurch gekennzeichnet, dass**, wenn der Ionenimplanter eine Rekuperationselektrode (LIN) am Rand des Substrats (SUB) umfasst, die Elektrode während der Ausstoßphase ([4]) positiv polarisiert ist.

4. Verfahren nach einem der vorhergehenden Ansprüche, **dadurch gekennzeichnet, dass** an das Substrat (SUB) während der Suppressionsphase ([3]) eine positive oder keine Polarisation (S) angelegt ist.

5. Polarisationsversorgung für einen Ionenimplanter, umfassend:

   - einen ersten elektrischen Generator (HT), dessen Pluspol mit der Masse verbunden ist,
   - einen ersten Schalter (SW1), dessen erster Pol mit dem Minuspol des ersten Generators (HT) verbunden ist und dessen zweiter Pol mit der Ausgangsklemme (S) dieser Versorgung (PS) verbunden ist,
   - einen zweiten Schalter (SW2), dessen erster Pol mit einer Kompensationsklemme (P) verbunden ist und dessen zweiter Pol mit der Ausgangsklemme (S) verbunden ist, **dadurch gekennzeichnet, dass** er einen Hilfsgenerator (GA) umfasst, dessen Pluspol mit einer Verbindungsklemme (L) verbunden ist, und einen dritten Schalter (SW3), dessen erster Pol mit dem Minuspol des Hilfsgenerators (GA) und dessen zweiter Pol mit der Ausgangsklemme (S) verbunden ist.

6. Versorgung nach Anspruch 5, **dadurch gekennzeichnet, dass** die Verbindungsklemme (L) mit der Masse verbunden ist.

7. Versorgung nach Anspruch 5, **dadurch gekenn-**

**zeichnet, dass**, wenn dieser Ionenimplanter eine Rekuperationselektrode (LIN) umfasst, die Verbindungsklemme (L) mit dieser Rekuperationselektrode verbunden ist.

8. Versorgung nach einem der Ansprüche 5 bis 7, **dadurch gekennzeichnet, dass** die Kompensationsklemme (P) mit der Masse verbunden ist.

9. Versorgung nach einem der Ansprüche 5 bis 7, **dadurch gekennzeichnet, dass** die Kompensationsklemme (P) mit dem Pluspol eines zweiten Generators (GP) verbunden ist, wobei der Minuspol dieses zweiten Generators (GP) mit der Masse verbunden ist.

## Claims

1. A method of controlling an ion implanter operating in plasma immersion of a substrate, the method comprising:

   • an implantation stage ([1]) during which the plasma (AP) is ignited and the substrate (SUB) is negatively biased (S);
   • a neutralization stage ([2]) during which the plasma (AP) is ignited and the substrate (SUB) has a positive or zero bias (S) applied thereto;
   • a suppression stage ([3]) during which the plasma (AP) is extinguished; and
   • an expulsion stage ([4]) for expelling negatively charged particles from the substrate (SUB) and during which the plasma (AP) is extinguished;

   in which the duration of said expulsion stage is longer than 5 $\mu$s, and
   **characterized in that**, following said expulsion stage ([4]), it includes a preparation stage ([5]) during which the plasma (AP) is extinguished and the substrate (SUB) has a positive or negative bias (S) applied thereto.

2. A method according to claim 1, **characterized in that**, during said expulsion stage ([4]), the substrate (SUB) is negatively biased (S).

3. A method according to any one of claims 1 to 2, **characterized in that** said ion implanter includes a recovery electrode (LIN) at the periphery of the substrate (SUB), and during said expulsion stage ([4]) said electrode is positively biased.

4. A method according to any preceding claim, **characterized in that** during said suppression stage ([3]), the substrate (SUB) has a positive or negative bias (S) applied thereto.

5.  A power supply for biasing an ion implanter, the power supply comprising:

    • a first electricity generator (HT) having its positive pole connected to ground;
    • a first switch (SW1) having its first pole connected to the negative pole of said first generator (HT), and having its second pole connected to the output terminal (S) of the power supply (PS); and
    • a second switch (SW2) having its first pole connected to a compensation terminal (P), and having its second pole connected to said output terminal (S);

    the power supply being **characterized in that** it includes an auxiliary generator (GA) having its positive pole connected to a link terminal (L), and a third switch (SW3) having its first pole connected to the negative pole of the auxiliary generator (GA), and its second pole connected to said output terminal (S)

6.  A power supply according to claim 5, **characterized in that** said link terminal (L) is connected to ground.

7.  A power supply according to claim 5, **characterized in that** the ion implanter includes a recovery electrode (LIN), and said link terminal (L) is connected to the recovery electrode.

8.  A power supply according to any one of claims 5 to 7, **characterized in that** said compensation terminal (P) is connected to ground.

9.  A power supply according to any one of claims 5 to 7, **characterized in that** said compensation terminal (P) is connected to the positive pole of a second generator (GP), the negative pole of the second generator (GP) being connected to ground.

Fig. 1

Fig. 2

Fig.3

Fig. 4

Fig. 5

Fig. 6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- WO 0115200 A
- US 2007069157 A
- WO 2013057390 A
- FR 2998707